# EUROPEAN PATENT SPECIFICATION

(11) **EP 2 504 387 B1**
(45) Date of publication and mention of the grant of the patent: **12.08.2015**
(21) Application number: 10781508.6
(22) Date of filing: 23.11.2010
(51) Int. Cl.: C08K 5/132, H01L 31/048

(54) **PHOTOVOLTAIC MODULE WITH UV-STABILIZED ENCAPSULANT**
PV-MODUL MIT UV-STABILISIERTEM VERKAPSELUNGSSTOFF
MODULE PHOTOVOLTAÏQUE À AGENT D'ENCAPSULATION STABILISÉ AUX UV

(30) Priority: 27.11.2009 EP 09177360
(43) Date of publication of application: 03.10.2012
(73) Proprietor: BASF SE, 67056 Ludwigshafen (DE)
(72) Inventor: FUJIKI, Daisuke, CH-4102 Binningen (CH)
(74) Representative: Lindner, Anton
(86) International application number: PCT/EP2010/067991
(87) International publication number: WO 2011/064192

(56) References cited:
- JP-A- 3 081 245

## Description

Photovoltaic modules comprise in addition to a photovoltaic semiconductor up to several layers out of synthetic polymers. As encapsulant, one or more layers out of synthetic polymers serve for several functions. For example, the structure of the photovoltaic module is supported, protection againt external mechanical stress is provided, isolation - also electrical - against the environment is achieved and thermal energy is transferred away from the circuit.
In case of a layer placed between the photovoltaic semiconductor and the external irradiation source, a high transparency of the layer for light is required for a high efficiency rate of the photovoltaic module - initially and during long-term use. Thus, discoloration of the layer is not only an aesthetic issue. Instead, this general indicator for polymer degradation by detrimental environmental effects like light and heat has got a significant further impact.

Some synthetic polymers used as encapsulants in photovoltaic modules can be crosslinked, for example if the crosslinking results in more suitable mechanical properties. The cross-linking itself is often initiated during the processing step of the synthetic polymer by an organic compound with a peroxide functionality. If other additives are also present in the synthetic polymer during the processing step, the presence of peroxide during the processing step at high temperatures might not only lead to the desired interaction with the polymer chains resulting in covalent bond formation between the latter ones. Instead, interaction with the additives might also take place to a certain degree. The interaction can lead to a decreased rate of crosslinking and / or to a final extent of crosslinking in the synthetic polymer, which is lower than that final extent obtainable with the same amount of peroxide in the absence of the additives. Especially the presence of additives for stabilization against degradation by oxidation, light and heat is a known obstacle in peroxide-induced crosslinking, as stated for example in Plastics Additives Handbook, page 766, 5th edition, 2001, edited by H. Zweifel, Hanser Publishers, Munich.

Furthermore, the added amount of organic compounds with a peroxide functionality might be increased to achieve the desired extent of crosslinking during the processing step. However, residuals of remaining peroxide or by-products thereof might interfere detrimentally with the long-term stability against oxidation, heat and light of the crosslinked polymer. In parallel, the additives involved in the long-term stabilization against oxidation, heat and light can be impaired in their activity by the interactions at the peroxide-induced crosslinking during the processing step.
Therefore, additives with a low interaction during crosslinking of synthetic polymers induced by organic compounds containing a peroxide functionality are desirable for a layer in photovoltaic modules.

In 'Investigation of the degradation and stabilization of EVA-based encapsulant in field-aged solar energy modules', Polymer Degradation and Stability, 1997, 555, 347-365, Elsevier Science Ltd, describes the discoloration phenomenon of poly(ethylene-co-vinylacetate)-based encapsulants in photovoltaic modules and the employment of a benzophenone derivative, i.e. (2-hydroxy-4-octyloxy-phenyl)phenylmethanone, as UV-absorber.

JP-A-2008-159856 discloses in its examples the use of a benzophenone derivative, i.e. (2,4-dihydroxy-phenyl)phenylmethanone, as an UV-absorber in poly(ethylene-co-vinylacetate) together with an organic peroxide as crosslinker and a hindered amine light stabilizer.

US-3580927 discloses the synthesis of dimeric benzophenone derivatives useful as UV-absorbers for synthetic polymers.

JP-B-47048888 discloses the employment of dimeric benzophenone derivatives for stabilization of several polymers processed at relatively high temperatures.

The present invention relates to a photovoltaic module comprising the components:
(1) a photovoltaic semiconductor and
(2) one or more layers containing
   (A) a synthetic polymer and
   (B) an UV absorber of the formula I 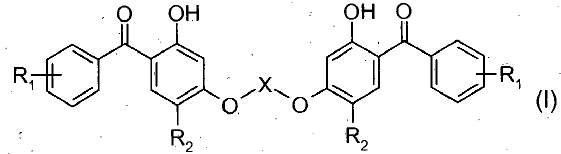 wherein
      X is a straight or branched chain C₁-C₁₆ alkylene, o-, m- or p-xylylene or an oxaalkanediyl of the formulae-CH₂CH₂[OCH₂CH₂]ₙ-, -CH₂CH(CH₃)[OOH₂CH(CH₃)]ₙ- or -CH₂CH₂CH₂[OCH₂CH₂CH₂]ₙ-, where n is 1 -4;
      R₁ is hydrogen, straight or branched chain C₁-C₁₈ alkyl, straight or branched chain C₁-C₁₈ alkoxy or chloro;
      R₂ is hydrogen or straight or branched chain C₁-C₁₈ alkyl.
Examples for straight or branched chain C₁-C₁₆ alkylene are methylene, ethylene, 1,3-propylene, 1-methylethylene, 1,4-butylene, 1,5-pentylene, 1,4-(2-methyl)butylene, 1,3-(2,2-dimethyl)propylene, 1,6-hexamethylene, 1,8-octylene, 1,10-decylene.
Especially preferred are C₂-C₁₀ alkylene, in particular C₃-C₈ alkylene. Preferred examples are ethylene, 1,3-propylene, 1,4-butylene and 1,6-hexamethylene.

Examples for straight or branched chain C₁-C₁₈ alkyl are methyl, ethyl, *n*-propyl, 1-methylethyl, *n*-butyl, 2-methylpropyl, 1-methylpropyl, *tert*-butyl, pentyl, 1-methylbutyl, 2-methylbutyl, 3-methylbutyl, 1,1'-dimethylpropyl, 1-ethylpropyl, *tert*-butylmethyl, hexyl, 1-methylpentyl, heptyl, isoheptyl, 2-ethylpentyl, 1-propylbutyl, octyl, isooctyl, 1-ethylhexyl, 2-ethylhexyl, 1,1,3,3-tetramethylbutyl, 2,4,4-trimethylpentyl, nonyl, isononyl, noononyl, undecyl, lauryl, tridecyl, tetradecyl, pentadecyl, hexadecyl and octadecyl.
Preferred is C₁-C₁₂ alkyl, especially C₁-C₈ alkyl, in particular C₁-C₄ alkyl. Preferred examples are methyl and *tert*-butyl*.*

Examples for straight or branched chain C₁-C₁₈ alkyloxy are methyloxy, ethyloxy, 2-methylethyloxy, propyloxy (= propoxy), butyloxy, hexyloxy, octyloxy and 2-ethylhexyloxy. Preferred is C₁-C₈ alkyloxy. Preferred examples are methyloxy, octyloxy and 2-ethylhexyloxy.

Preferred is a photovoltaic module wherein in formula I X is C₂-C₁₀ alkylene.

Preferred is a photovoltaic module wherein in formula I R₂ is hydrogen or *tert*-butyl.

Preferred is a photovoltaic module wherein in formula I R₁ is hydrogen, *tert*-butyl, methoxy or chloro.

Preferred is a photovoltaic module wherein in formula I R₁ is hydrogen, *tert*-butyl or methoxy or chloro, R₂ is hydrogen and X is C₃-C₈ alkylene.

Preferred is a photovoltaic module wherein in formula I X is C₃-C₈ alkylene, and R₂ are hydrogen.

Preferred is a photovoltaic module wherein in formula I in formula I X is *n*-butylene or hexamethylene.

Especially preferred is a photovoltaic module wherein component (B) is 4-[4-(4-benzoyl-3-hydroxy-phenoxy)-butoxy]-2-hydroxy-phenyl}-phenyl-methanone or {4-[6-(4-benzoyl-3-hydroxy-phenoxy)-hexyloxy]-2-hydroxy-phenyl}-phenyl-methanone.

Very preferred is a photovoltaic module wherein component (B) is 4-[4-(4-benzoyl-3-hydroxy-phenoxy)-butoxy]-2-hydroxy-phenyl}-phenyl-methanone.

Examples for synthetic polymers are:
1. Polymers of monoolefins and diolefins, for example polypropylene, polyisobutylene, polybut-1-ene, poly-4-methylpent-1-ene, polyvinylcyclohexane, polyisoprene or polybutadiene, as well as polymers of cycloolefins, for instance of cyclopentene or norbornene, polyethylene (which optionally can be crosslinked), for example high density polyethylene (HDPE), high density and high molecular weight polyethylene (HDPE-HMW), high density and ultrahigh molecular weight polyethylene (HDPE-UHMW), medium density polyethylene (MDPE), low density polyethylene (LDPE), linear low density polyethylene (LLDPE), (VLDPE) and (ULDPE).
2. Mixtures of the polymers mentioned under 1), for example mixtures of polypropylene with polyisobutylene, polypropylene with polyethylene (for example PP/HDPE, PP/LDPE) and mixtures of different types of polyethylene (for example LDPE/HDPE).
3. Copolymers of monoolefins and diolefins with each other or with other vinyl monomers, for example ethylene/propylene copolymers, linear low density polyethylene (LLDPE) and mixtures thereof with low density polyethylene (LDPE), propylene/but-1-ene copolymers, propylene/isobutylene copolymers, ethylene/but-1-ene copolymers, ethylene/hexene copolymers, ethylene/methylpentene copolymers, ethylene/heptene copolymers, ethylehe/octene copolymers, ethylene/vinylcyclohexane copolymers, ethylene/cycloolefin copolymers (e.g. ethylene/norbornene like COC), ethylene/1-olefins copolymers, where the 1-olefin is generated in-situ; propylene/butadiene copolymers, isobutylene/isoprene copolymers, ethylene/vinylcyclohexene copolymers, ethylene/alkyl acrylate copolymers, ethylene/alkyl methacrylate copolymers, ethylene/vinyl acetate copolymers (poly(ethylene-co-vinylacetate), EVA) or ethylene/acrylic acid copolymers and their salts (ionomers) as well as terpolymers of ethylene with propylene and a diene such as hexadiene, dicyclopentadiene or ethylidenenorbornene; and mixtures of such copolymers with one another and with polymers mentioned in 1) above, for example polypropylene/ethylene-propylene copolymers, LDPE/ethylene-vinyl acetate copolymers (poly(ethylene-eo-vinylacetate), EVA), LDPE/ethylene-acrylic acid copolymers (EAA), LLDPE/EVA (ethylene-vinyl acetate copolymers, poly(ethylene-co-vinylacetate)), LLDPE/EAA and alternating or random polyalkylene/carbon monoxide copolymers and mixtures thereof with other polymers, for example polyamides.
4. Polymers derived from α,β-unsaturated acids and derivatives thereof such as polyacrylates and polymethacrylates; polymethyl methacrylates, polyacrylamides and polyacrylonitriles, impact-modified with butyl acrylate.
5. Polymers derived from unsaturated alcohols and amines or the acyl derivatives or acetals thereof, for example polyvinyl alcohol, polyvinyl acetate, polyvinyl stearate, polyvinyl benzoate, polyvinyl maleate, polyvinyl butyral, polyallyl phthalate or polyallyl melamine; as well as their copolymers with olefins mentioned in 1) above.
6. Polyphenylene oxides and sulfides, and mixtures of polyphenylene oxides with styrene polymers or polyamides.
7. Polyesters derived from dicarboxylic acids and diols and/or from hydroxycarboxylic acids or the corresponding lactones, for example polyethylene terephthalate, polybutylene terephthalate, poly-1,4-dimethylolcyclohexane terephthalate, polyalkylene naphthalate (PAN) and polyhydroxybenzoates, as well as block copolyether esters derived from hydroxyl-terminated polyethers; and also polyesters modified with polycarbonates or MBS.
8. Polycarbonates and polyester carbonates.
9. Polyurethane derived from hydroxy-terminated polyesters, polyesters or polybutadienes on the one hand and aliphatic or aromatic polyisocyanates on the other hand, as well as precursors thereof.
10. Polyamides and copolyamides derived from diamines and dicarboxylic acids and/or from aminocarboxylic acids or the corresponding lactams, for example polyamide 4, polyamide 6, polyamide 6/6, 6/10, 6/9, 6/12, 4/6, 12/12, polyamide 11, polyamide 12, aromatic polyamides starting from m-xylene diamine and adipic acid; polyamides prepared from hexamethylenediamine and isophthalic or/and terphthalic acid and with or without an elastomer as modifier, for example poly-2,4,4-trimethylhexamethylene terephthalamide or poly-m-phenylene isophthalamide; and also block copolymers of afore mentioned polyamides with polyolefins, olefin copolymers, ionomers or chemically bonded or grafted elastomers; or with polyethers, e.g. with polyethylene glycol, polypropylene glycol or polytetramethylene glycol; as well as polyamides or copolyamides modified with EPDM or ABS; and polyamides condensed during processing (RIM polyamide systems).
11. Blends of the aforementioned polymers (polyblends), for example PP/EPDM, Poly-amide/EPDM or ABS, PVC/EVA, PVC/ABS, PVC/MBS, PC/ABS, PBTP/ABS, PC/ASA, PC/PBT, PVC/CPE, PVC/acrylates, POM/thermoplastic PUR, PC/thermoplastic PUR, POM/acrylate, POM/MBS, PPO/HIPS, PPO/PA 6.6 and copolymers, PA/HDPE, PA/PP, PA/PPO, PBT/PC/ABS or PBT/PET/PC.
12. Polysiloxanes, for example silicone such as alkyl substituted silicone (e.g. methyl silicone), partially vinyl-substituted silicone (VMQ, e.g. vinyl methyl silicone), partially phenyl substituted silicone (PMQ, e.g. phenyl methyl silicone), partially vinyl and phenyl substituted silicone (PVMQ, e.g. phenyl vinyl methyl silicone), partially fluoroalkyl substituted silicone (FMQ, e.g. 3,3,3-trifluoropropyl methyl silicone), partially fluoroalkyl vinyl substituted silicone (FVMQ, e.g. 3,3,3-trifluoropropyl vinyl methyl silicone), partially aminoalkyl substituted silicone (e.g. 3-aminopropyl methyl silicone), partially carboxyalkyl substituted silicone (e.g. 3-carboxypropyl methyl silicone), partially alkoxy substituted silicone (e.g. ethoxy methyl silicone), partially allyl substituted silicone (e.g. allyl methyl silicone) or silicone resins (highly crosslinked silicone).

Preferred is a photovoltaic module wherein the component (A) is a synthetic polymer selected from poly(ethylene-co-vinylacetate), poly(ethylene-co-methacrylic acid) and salts thereof, poly(ethylene-co-acrylic acid) and salts thereof, polyurethane, poly(vinyl-butyral), polymethacrylate, polyacrylate, polyester and silicone.

The synthetic polymers can be thermoplastic or crosslinked.

Preferred is a photovoltaic module wherein the component (A) is a thermoplastic synthetic polymer.

Preferred is a photovoltaic module wherein the component (A) is a thermoplastic synthetic polymer and selected from poly(ethylene-co-vinylacetate), poly(ethylene-co-methacrylic acid) and salts thereof, poly(ethylene-co-acrylic acid) and salts thereof, polyurethane, poly(vinyl butyral), polymethacrylate, polyacrylate, polyester and silicone.

Preferred is a photovoltaic module wherein the component (A) is thermoplastic poly-(ethylene-co-vinylacetate).

Especially preferred is a photovoltaic module wherein component (A) is thermoplastic poly(ethlylene-co-vinylacetate) with a relative weight content of vinylacetate from 10% to 40%.

A crosslinked synthetic polymer can be formed already during polymerization, if the suitable monomers are chosen. Alternatively, crosslinking can also be achieved by a separate processing step for modification of an already formed thermoplastic polymer. In the latter case, additional covalent bonds are formed between the individual molecular chains in the polymer and hence, a three-dimensional network is built. Accordingly, several properties of the originally thermoplastic synthetic polymer are modified at the crosslinked synthetic polymer, for example the viscosity is significantly increased especially at higher temperatures.

A polymer is considered as crosslinked in this application, if the gel content is between 50% and 100%, whereupon 100% indicates full crosslinking. Particularly relevant is the gel content between 50% and 98%, especially between 80% and 95%.

The gel content of a polymer in regard to the present document is determined as following: 3 g of polymer are dissolved in 300 mL of xylene under reflux (at around 140°C) for 12 hours. After cooling down to room temperature, the undissolved residuals are isolated by filtration over a 100 mesh metal net. The residuals are dried at 120°C for 4 hours under vacuum. The weight ratio of the dried residuals versus the original amount of polymer is the gel content.

Preferred is a photovoltaic module wherein the component (A) is a crosslinked synthetic polymer.

Several thermoplastic polymers are especially suitable for crosslinking, for example polyethylene, ethylene/1-olefins copolymers, terpolymers of ethylene with propylene and a diene such as hexadiene, dicyclopentadiene or ethylidene-norbornene, poly(ethylene-co-vinylacetate), poly(vinyl butyral), polymethacrylate, polyacrylate and silicone.

Preferred is a photovoltaic module wherein the component (A) is a crosslinked polymer selected from poly(ethylene-co-vinylacetate), poly(vinyl butyral) and silicone.

Preferred is a photovoltaic module wherein the component (A) is crosslinked poly(ethylene-co-vinylacetate).

Preferred is a photovoltaic moducle wherein the component (A) is crosslinked poly(ethylene-co-vinylacetate) with a relative weight content of vinylacetate from 10% to 40%.

The crosslinking process can be induced by addition of organic compounds with peroxide functionalities and exposure of the polymer to higher temperatures, since at higher temparatures the peroxide functionalities lead to the generation of reactive radicals. These radicals start said covalent bond formation reactions between different molecular chains of the synthetic thermoplastic polymer. The final degree of crosslinking of a certain thermoplastic synthetic polymer and also the crosslinking kinetics are dependent inter alia on the type and the amount of employed organic peroxide compounds, the process conditions like temperature and exposure time to a certain temperature. Furthermore, additives present in the thermoplastic synthetic polymer might influence the crosslinking process.

Examples for organic compounds with peroxide functionality are:
1. Hydroperoxides, for example *tert*-butylhydroperoxide or cumylhydroperoxide.
2. Alkyl / aryl peroxides, for example di-*tert*-butylperoxide, di-*tert*-amylperoxide, 2,2-bis-(*tert*-butylperoxy)butane, 2,5-dimethyl-2,5-di-(*tert*-butylperoxy)hexane, 2,5-dimethyl-3-hexyne-2,5-di-*tert*-butylperoxide, dicumylperoxide, bis-(1-*tert*-butylperoxy-1-methylethyl)-benzene, α,α'-bis-(*tert*-butylperoxy)diisopropylbenzene, 1,4-bis-(*tert-*butylperoxydiisopropyl)benzene or *tert*-butylcumylperoxide.
3. Peroxyesters, for example *tert*-butylperoxy benzoate, *tert*-butylperoxy 2-ethylhexanoate, *tert*-butyl-peroxy 3,5,5-trimethylhexanoate, didecanoyl peroxide, dilauroyl peroxide or succinic acid peroxide.
4. Peroxycarbonates, for example peroxycarbonic acid *O*-*O*-*tert*-butyl ester *O*-isopropyl ester or peroxycarbonic acid *O-O-tert*-butylester *O*-(2-ethylhexyl) ester.
5. Diaroylperoxides, for example dibenzoylperoxide, di-(4-chlorobenzoyl)peroxide, di(2,4-dichlorobenzoyl)peroxide or di-(4-methylbenzoyl)peroxide.
6. Peroxyketals, for example 1,1-di-*tert*-butylperoxy-3,5,5-trimethyl-cyclohexane, 1,1-di-(*tert*-amylperoxy)cyclohexane, ethyl 3,3-di-(*tert*-amylperoxy)butanoate or *n*-butyl 4,4-di-(*tert*-butylperoxy)valerate.
7. Cyclic peroxides, for example 3,6,9-triethyl-3,6,9-trimethyl-[1,2,4,5,7,8]hexoxonane or 3,3,6,6,9,9-hexamethyl-1,2,4,5-tetraoxocyclohexane.

Several organic peroxide compounds are commercially available, for example 2,5-dimethyl-2,5-di-(*tert*-butylperoxy)hexane contained in Luperox 101 (RTM Arkema Inc.) or peroxycarbonic acid *O*-*O*-*tert*-butyl ester *O*-isopropyl ester contained in Luperox TBEC (RTM Arkema Inc.).

Preferred is a photovoltaic module wherein the component (A) is a crosslinked synthetic polymer, wherein the crosslinking originates from addition of an organic compound with peroxide functionality to a formerly thermoplastic polymer.

Preferred is a photovoltaic module wherein the component (A) is a crosslinked synthetic polymer, wherein the crosslinking originates from addition of an organic compound with peroxide functionality to a formerly thermoplastic polymer, and wherein the organic compound with peroxide functionality is selected from didecanoyl peroxide, dilauroyl peroxide, succinic acid peroxide, dibenzoyl peroxide, dicumyl peroxide, 2,5-di-(*tert-*butylperoxy)-2,5-dimethylhexane, *tert*-butyl-cumyl peroxide, α,α'-bis-(*tert*-butylperoxy)-diisopropylbenzene, di-*tert*-amyl peroxide, di-*tert*-butyl peroxide, 2,5-di-(*tert*-butylperoxy)-2,5-dimethyl-3-hexyne, 1,1-di-(*tert*-butylperoxy)-3,3,5-trimethylcyclohexane, 1,1-di-*tert-*butylperoxy)-cyclohexane, 1,1-di-(*tert*-amylperoxy)cyclohexane, *n*-butyl 4,4-di-(*tert-*butylperoxy)valerate, ethyl 3,3-di-(*tert*-amylperoxy)butanoate, ethyl 3,3-di-(*tert-*butylperoxy)butyrate and *tert*-butylperoxy 2-ethylhexyl carbonate.

Especially preferred is peroxycarbonic acid *O*-*O*-*tert*-butyl ester *O*-isopropyl ester.

Preferred is a photovoltaic module wherein the component (A) is a crosslinked synthetic polymer, which is selected from poly(ethylene-co-vinylacetate), poly(vinyl butyral) and partially vinyl substituted silicone, and wherein the crosslinking originates from addition of an organic compound with peroxide functionality to a formerly thermoplastic polymer

Preferred is a photovoltaic module wherein the component (A) is crosslinked poly(ethylene-co-vinylacetate), wherein the crosslinking originates from addition of an organic compound with peroxide functionality to a formerly thermoplastic poly(ethylene-co-vinylacetate).

Preferred is a photovoltaic moducle wherein the component (A) is crosslinked poly(ethylene-co-vinylacetate) with a relative weight content of vinylacetate from 10% to 40%, wherein the crosslinking originates from addition of an organic compound with peroxide functionality to a formerly thermoplastic poly(ethylene-co-vinylacetate).

Typical photovoltaic modules contain, for example, the following layers:
- photovoltaic module I:
   (a) front support layer
   (b) encapsulant layer
      crystalline silicon layer as photovoltaic semiconductor
   (b) encapsulant layer
   (c) back substrate layer
- photovoltaic module II:
   front support layer
   transparent conductor layer
   amorphous silicon layer as photovoltaic semiconductor
   back contact layer
   encapsulant layer
   back substrate layer
- photovoltaic module III:
   front support layer
   encapsulant layer
   transparent conductor layer
   composite semiconductor as photovoltaic semiconductor
   back contact layer
   back substrate layer
- photovoltaic module IV:
   front support layer
   transparent conductor layer
   composite semiconductor as photovoltaic semiconductor
   transparent conductor layer
   encapsulant layer
   back substrate layer

Preferred is a photovoltaic module wherein the layer or layers of component (2) are selected from a front support layer, an encapsulant layer and a back substrate layer.

The front support layer, the encapsulant layer and the back substrate layer are advantageously made of a synthetic polymer. If desired, the front support layer and/or the back substrate layer may alternatively be made for example out of glass or metal.

The photovoltaic module contains a photovoltaic semiconductor. Photovolatic semiconductors contain for example crystalline silicon, armorphous silicon or - in case of composite semiconductors - CuInSe₂ (CIS), Cu(InGa)Se₂ (CIGS), Cu(InGa)(SSe)₂ or CdTe-CdS.

Preferred is a photovoltaic module wherein the photovoltaic semiconductor (1) contains crystalline silicon, amorphous silicon, CuInSe₂, Cu(InGa)Se₂ or CdTe-CdS.

The layer of layers of component (2) of the photovoltaic module may contain beneath component (B) a further additive.

Examples for a further additive are:
1. Antioxidants
   1.1. Alkylated monophenols, for example 2,6-di-*tert*-butyl-4-methylphenol, 2-*tert*-butyl-4,6-dimethylphenol, 2,6-di-*tert*-butyl-4-ethylphenol, 2,6-di-*tert*-butyl-4-n-butylphenol, 2,6-di-*tert*-butyl-4-isobutylphenol, 2,6-dicyclopentyl-4-methylphenol, 2-(α-methylcyclohexyl)-4,6-dimethylphenol, 2,6-dioctadecyl-4-methylphenol, 2,4,6-tricyclohexylphenol, 2,6-di-*tert*-butyl-4-methoxymethylphenol, nonylphenols which are linear or branched in the side chains, for example, 2,6-di-nonyl-4-methylphenol, 2,4-dimethyl-6-(1'-methylundec-1'-yl)phenol, 2,4-dimethyl-6-(1'-methylheptadec-1'-yl)phenol, 2,4-dimethyl-6-(1'-methyltridec-1'-yl)phenol and mixtures there-of.
   1.2. Alkylthiomethylphenols, for example 2,4-dioctylthiomethyl-6-*tert*-butylphenol, 2,4-dioctyl-thiomethyl-6-methylphenol, 2,4-dioctylthiomethyl-6-ethylphenol, 2,6-di-dodecylthiomethyl-4-nonylphenol.
   1.3. Hydroquinones and alkylated hydroquinones, for example 2,6-di-*tert*-butyl-4-methoxyphenol, 2,5-di-*tert*-butylhydroquinone, 2,5-di-*tert*-amylhydroquinone, 2,6-diphenyl-4-octade-cyloxyphenol, 2,6-di-*tert*-butylhydroquinone, 2,5-di-*tert*-butyl-4-hydroxyanisole, 3,5-di-*tert*-butyl-4-hydroxyanisole, 3,5-di-*tert*-butyl-4-hydroxyphenyl stearate, bis(3,5-di-*tert*-butyl-4-hydroxyphenyl) adipate.
   1.4. Tocopherols, for example α-tocopherol, β-tocopherol, γ-tocopherol, δ-tocopherol and mixtures thereof (vitamin E).
   1.5. Hydroxylated thiodiphenyl ethers, for example 2,2'-thiobis(6-*tert*-butyl-4-methylphenol), 2,2'-thiobis(4-octylphenol), 4,4'-thiobis(6-*tert*-butyl-3-methylphenol), 4',4'-thiobis(6-*tert*-butyl-2-methylphenol), 4,4'-thiobis(3,6-di-sec-amylphenol), 4,4'-bis(2,6-dimethyl-4-hydroxyphenyl)-disulfide.
   1.6. Alkylidenebisphenols, for example 2,2'-methylenebis(6-*tert*-butyl-4-methylphenol), 2,2'-methylenebis(6-*tert*-butyl-4-ethylphenol), 2,2'-methylenebis[4-methyl-6-(α-methylcyclohexyl)-phenol], 2,2'-methylenebis(4-methyl-6-cyclohexylphenol), 2,2'-methylenebis(6-nonyl-4-methylphenol), 2,2'-methylenebis(4,6-di-*tert*-butylphenol), 2,2'-ethylidenebis(4,6-di-*tert*-butylphenol), 2,2'-ethylidenebis(6-*tert*-butyl-4-isobutylphenol), 2,2'-methylenebis[6-(α-methylbenzyl)-4-nonylphenol], 2,2'-methylenebis[6-(α,α-dimethylbenzyl)-4-nonylphenol], 4,4'-methy-lenebis(2,6-di-*tert*-butylphenol), 4,4'-methylenebis-(6-*tert*-butyl-2-methylphenol), 1,1-bis-(5-*tert*-butyl-4-hydroxy-2-methylphenyl)butane, 2,6-bis-(3-*tert*-butyl-5-methyl-2-hydroxybenzyl)-4-methylphenol, 1,1,3-tris-(5-*tert*-butyl-4-hydroxy-2-methylphenyl)butane, 1,1-bis-(5-*tert-*butyl-4-hydroxy-2-methyl-phenyl)-3-*n*-dodecylmercaptobutane, ethylene glycol bis-[3,3-bis-(3'-*tert*-butyl-4'-hydroxyphenyl)butyrate], bis-(3-*tert*-butyl-4-hydroxy-5-methyl-phenyl)dicyclopentadiene, bis[2-(3'-*tert*-butyl-2'-hydroxy-5'-methylbenzyl)-6-*tert*-butyl-4-methylphenyl]terephthalate, 1,1-bis-(3,5-dimethyl-2-hydroxyphenyl)butane, 2,2-bis-(3,5-di-*tert*-butyl-4-hydroxyphenyl)propane, 2,2-bis-(5-*tert*-butyl-4-hydroxy-2-methylphenyl)-4-*n-*dodecylmercaptobutane, 1,1,5,5-tetra-(5-*tert*-butyl-4-hydroxy-2-methylphenyl)pentane.
   1.7. O-, N- and S-benzyl compounds, for example 3,5,3',5'-tetra-*tert*-butyl-4,4'-dihydroxydibenzyl ether, octadecyl-4-hydroxy-3,5-dimethylbenzylmercaptoacetate, tridecyl-4-hydroxy-3,5-di-*tert*-butylbenzylmercaptoacetate, tris-(3,5-di-*tert*-butyl-4-hydroxybenzyl)amine, bis-(4-*tert*-butyl-3-hydroxy-2,6-dimethylbenzyl)dithioterephthalate, bis-(3,5-di-*tert*-butyl-4-hydroxybenzyl)sulfide, isooctyl-3,5-di-*tert*-butyl-4-hydroxybenzylmercaptoacetate.
   1.8. Hydroxybenzylated malonates, for example dioctadecyl-2,2-bis(3,5-di-*tert*-butyl-2-hydroxybenzyl)malonate, di-octadecyl-2-(3-*tert*-butyl-4-hydroxy-5-methylbenzyl)malonate, di-dodecylmercaptoethyl-2,2-bis (3,5-di-*tert*-butyl-4-hydroxybenzyl)malonate, bis-[4-(1,1,3,3-tetramethylbutyl)phenyl]-2,2-bis-(3,5-di-*tert*-butyl-4-hydroxybenzyl)malonate.
   1.9. Aromatic hydroxybenzyl compounds, for example 1,3,5-tris-(3,5-di-*tert*-butyl-4-hydroxy-benzyl)-2,4,6-trimethylbenzene, 1,4-bis-(3,5-di-*tert*-butyl-4-hydroxybenzyl)-2,3,5,6-tetramethylbenzene, 2,4,6-tris-(3,5-di-*tert*-butyl-4-hydroxybenzyl)phenol.
   1.10. Triazine compounds, for example 2,4-bis-(octylmercapto)-6-(3,5-di-*tert*-butyl-4-hydroxy-anilino)-1,3,5-triazine, 2-octylmercapto-4,6-bis-(3,5-di-*tert*-butyl-4-hydroxyanilino)-1,3,5-triazine, 2-octylmercapto-4,6-bis-(3,5-di-*tert*-butyl-4-hydroxyphenoxy)-1,3,5-triazine, 2,4,6-tris-(3,5-di-*tert*-butyl-4-hydroxyphenoxy)-1,2,3-triazine, 1,3,5-tris-(3,5-di-*tert*-butyl-4-hydroxybenzyl)isocyanurate, 1,3,5-tris-(4-*tert*-butyl-3-hydroxy-2,6-dimethylbenzyl)isocyanurate, 2,4,6-tris(3,5-di-*tert*-butyl-4-hydroxyphenylethyl)-1,3,5-triazine, 1,3,5-tris-(3,5-di-*tert*-butyl-4-hydroxyphenylpropionyl)-hexahydro-1,3,5-triazine, 1,3,5-tris-(3,5-dicyclohexyl-4-hydroxybenzyl)isocyanurate.
   1.11. Benzylphosphonates, for example dimethyl-2,5-di-*tert*-butyl-4-hydroxybenzylphosphonate, diethyl-3,5-di-*tert*-butyl-4-hydroxybenzylphosphonate, dioctadecyl-3,5-di-*tert*-butyl-4-hydroxybenzylphosphonate, dioctadecyl-5-*tert*-butyl-4-hydroxy-3-methylbenzylphosphonate, the calcium salt of the monoethyl ester of 3,5-di-*tert*-butyl-4-hydroxybenzylphosphonic acid.
   1.12. Acylaminophenols, for example 4-hydroxylauranilide, 4-hydroxystearanilide; octyl *N-*(3,5-di-*tert*-butyl-4-hydroxyphenyl)carbamate.
   1.13. Esters of B-(3,5-di-*tert*-butyl-4-hydroxyphenyl)propionic acid with mono- or polyhydric alcohols, e.g. with methanol, ethanol, *n*-octanol, i-octanol, octadecanol, 1,6-hexanediol, 1,9-nonanediol, ethylene glycol, 1,2-propanediol, neopentyl glycol, thiodiethylene glycol, diethylene glycol, triethylene glycol, pentaerythritol, tris(hydroxyethyl)isocyanurate, *N*,*N*'-bis(hydroxyethyl)oxamide, 3-thiaundecanol, 3-thiapentadecanol, trimethylhexanediol, trimethylolpropane, 4-hydroxymethyl-1-phospha-2,6,7-trioxabicyclo[2.2.2]octane.
   1.14. Esters of β-(5-*tert*-butyl-4-hydroxy-3-methylphenyl)propionic acid with mono- or polyhydric alcohols, for example with methanol, ethanol, n-octanol, i-octanol, octadecanol, 1,6-hexanediol, 1,9-nonanediol, ethylene glycol, 1,2-propanediol, neopentyl glycol, thiodiethylene glycol, diethylene glycol, triethylene glycol, pentaerythritol, tris(hydroxyethyl)isocyanurate, *N*,*N*'-bis(hydroxyethyl)oxamide, 3-thiaundecanol, 3-thiapentadecanol, trimethylhexanediol, trimethylolpropane, 4-hydroxymethyl-1-phospha-2,6,7-trioxabicyclo[2.2.2]octane; 3,9-bis[2-{3-(3-*tert*-butyl-4-hydroxy-5-methylphenyl)propionyloxy}-1,1-dimethylethyl]-2,4,8,10-tetraoxaspiro[5.5]undecane.
   1.15. Esters of β-(3,5-dicyclohexyl-4-hydroxyphenyl)propionic acid with mono- or polyhydric alcohols, for example with methanol, ethanol, octanol, octadecanol, 1,6-hexanediol, 1,9-nonanediol, ethylene glycol, 1,2-propanediol, neopentyl glycol, thiodiethylene glycol, diethylene glycol, triethylene glycol, pentaerythritol, tris(hydroxyethyl)isocyanurate, *N*,*N*'-bis(hydroxyethyl)oxamide, 3-thiaundecanol, 3-thiapentadecanol, trimethylhexanediol, trimethylolpropane, 4-hydroxymethyl-1-phospha-2,6,7-trioxabicyclo[2.2.2]octane.
   1.16. Esters of 3,5-di-*tert*-butyl-4-hydroxyphonyl acetic acid with mono- or polyhydric alcohols, for example with methanol, ethanol, octanol, octadecanol, 1,6-hexanediol, 1,9-nonanediol, ethylene glycol, 1,2-propanediol, neopentyl glycol, thiodiethylene glycol, diethylene glycol, triethylene glycol, pentaerythritol, tris(hydroxyethyl)isocyanurate, *N*,*N*'-bis-(hydroxyethyl)oxamide, 3-thiaundecanol, 3-thiapentadecanol, trimethylhexanediol, trimethylolpropane, 4-hydroxymethyl-1-phospha-2,6,7-trioxabicyclo[2.2.2]octane.
   1.17. Amides of β-(3,5-di-*tert*-butyl-4-hydroxyphenyl)propionic acid, for example *N*,*N*'-bis(3,5-di-*tert*-butyl-4-hydroxyphenylpropionyl)hexamethylenediamide, *N*,*N*'-bis(3,5-di-*tert*-butyl-4-hydroxyphenylpropionyl)trimethylenediamide, *N*,*N*'-bis(3,5-di-*tert*-butyl-4-hydroxyphenylpropionyl)hydrazide, *N*,*N*'-bis[2-(3-[3,5-di-*tert*-butyl-4-hydroxyphenyl]propionyloxy)ethyl]oxamide.
   1.18. Ascorbic acid (vitamin C)
   1.19. Aminic antioxidants, for example *N*,*N*'-di-isopropyl-*p*-phenylenediamine, *N*,*N*'-di-sec-butyl-*p*-phenylenediamine, *N*,*N*'-bis(1,4-dimethylpentyl)-*p*-phenylenediamine, *N*,*N*'-bis-(1-ethyl3-methylpentyl)-*p*-phenylenediamine, *N*,*N*'-bis(1-methylheptyl)-*p*-phenylenediamine, *N,N'-*dicyclohexyl-*p*-phenylenediamine, *N*,*N*'-diphenyl-*p*-phenylenediamine, *N,N*'-bis-(2-naphthyl)-*p*-phenylenediamine, *N*-isopropyl-*N*'-phenyl-*p*-phenylenediamine, *N*-(1,3-dimethylbutyl)-*N*'-phenyl-*p*-phenylenediamine, *N*-(1-methylheptyl)-*N*'-phenyl-*p*-phenylenediamine, *N-*cyclohexyl-*N*'-phenyl-*p*-phenylenediamine, 4-(*p*-toluenesulfamoyl)diphenylamine, *N,N'-*dimethyl-*N*,*N*'-di-*sec*-butyl-*p*-phenylenediamine, diphenylamine, *N*-allyldiphenylamine, 4-isopropoxydiphenylamine, *N*-phenyl-1-naphthylamine, *N*-(4-*tert*-octylphenyl)-1-naphthylamine, *N*-phenyl-2-naphthylamine, octylated diphenylamine, for example *p*,*p*'-di-*tert-*octyldiphenylamine, 4-*n*-butylaminophenol, 4-butyrylaminophenol, 4-nonanoylaminophenol, 4-dodecanoylaminophenol, 4-octadecanoylaminophenol, bis(4-methoxyphenyl)amine, 2,6-di-*tert*-butyl-4-dimethylaminomethylphenol, 2,4'-diaminodiphenylmethane, 4,4'-diaminodiphenylmethane, *N*,*N*,*N*',*N*'-tetramethyl-4,4'-diaminodiphenylmethane, 1,2-bis-[(2-methylphenyl)amino]ethane, 1,2-bis(phenylamino)propane, (o-tolyl)biguanide, bis[4-(1',3'-dimethylbutyl)phenyl]amine, *tert*-octylated *N*-phenyl-1-naphthylamine, a mixture of mono-and dialkylated *tert*-butyl/*tert*-octyldiphenylamines, a mixture of mono- and dialkylated nonyldiphenylamines, a mixture of mono- and dialkylated dodecyldiphenylamines, a mixture of mono- and dialkylated isopropyl/isohexyldiphenylamines, a mixture of mono- and dialkylated *tert*-butyldiphenylamines, 2,3-dihydro-3,3-dimethyl-4H-1,4-benzothiazine, phenothiazine, a mixture of mono- and dialkylated *tert*-butyl/*tert*-octylphenothiazines, a mixture of mono- and dialkylated *tert*-octyl-phenothiazines, *N*-allylphenothiazine, *N,N,N',N'-*tetraphenyl-1,4-diaminobut-2-ene.
2. UV absorbers and light stabilizers
   2.1. 2-(2'-Hydroxyphenyl)benzotriazoles, for example 2-(2'-hydroxy-5'-methylphenyl)-benzotriazole, 2-(3',5'-di-*tert*-butyl-2'-hydroxyphenyl)benzotriazole, 2-(5'-*tert*-butyl-2'-hydroxyphenyl)benzotriazole, 2-(2'-hydroxy-5'-(1,1,3,3-tetramethylbutyl)phenyl)benzotriazole, 2-(3',5'-di-*tert*-butyl-2'-hydroxyphenyl)-5-chloro-benzotriazole, 2-(3'-*tert*-butyl-2'-hydroxy-5'-methylphenyl)-5-chloro-benzotriazole, 2-(3'-sec-butyl-5'-tert-butyl-2'-hydroxyphenyl)benzotriazole, 2-(2'-hydroxy-4'-octyloxyphenyl)benzotriazole, 2-(3',5'-di-*tert*-amyl-2'-hydroxyphenyl)benzotriazole, 2-(3',5'-bis-(α,α-dimethylbenzyl)-2'-hydroxyphenyl)benzotriazole, 2-(3'-*tert*-butyl-2'-hydroxy-5'-(2-octyloxycarbonylethyl)phenyl)-5-chloro-benzotriazole, 2-(3'-*tert*-butyl-5'-[2-(2-ethylhexyloxy)-carbonylethyl]-2'-hydroxyphenyl)-5-chloro-benzotriazole, 2-(3'-*tert*-butyl-2'-hydroxy-5'-(2-methoxycarbonylethyl)phenyl)-5-chloro-benzotriazole, 2-(3'-*tert*-butyl-2'-hydroxy-5'-(2-methoxycarbonylethyl)phenyl)benzotriazole, 2-(3'-*tert*-butyl-2'-hydroxy-5'-(2-octyloxycarbonylethyl)phenyl)benzotriazole, 2-(3'-*tert*-butyl-5'-[2-(2-ethylhexyloxy)carbonylethyl]-2'-hydroxyphenyl)benzotriazole, 2-(3'-dodecyl-2'-hydroxy-5'-methylphenyl)benzotriazole, 2-(3'-*tert*-butyl-2'-hydroxy-5'-(2-iso-octyloxycarbonylethyl)phenylbenzotriazole, 2,2'-methylene-bis-[4-(1,1,3,3-tetramethylbutyl)-6-benzotriazole-2-ylphenol]; the transesterification product of 2-[3'-tert-butyl-5'-(2-methoxycarbonylethyl)-2'-hydroxyphenyl]-2*H*-benzotriazole with polyethylene glycol 300; 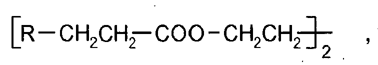 where R = 3'-*tert*-butyl-4'-hydroxy-5'-2*H-*benzotriazol-2-ylphenyl, 2-[2'-hydroxy-3'-(α,α-dimethylbenzyl)-5'-(1,1,3,3-tetramethylbutyl)-phenyl]benzotriazole; 2-[2'-hydroxy-3'-(1,1,3,3-tetramethylbutyl)-5'-(α,α-dimethylbenzyl)-phenyl]benzotriazole.
   2.2. 2-Hydroxybenzophenones, for example the 4-hydroxy, 4-methoxy, 4-octyloxy, 4-decyloxy, 4-dodecyloxy, 4-benzyloxy, 4,2',4'-trihydroxy and 2'-hydroxy-4,4'-dimethoxy derivatives.
   2.3. Esters of substituted and unsubstituted benzoic acids, for example 4-*tert*-butyl-phenyl salicylate, phenyl salicylate, octylphenyl salicylate, dibenzoyl resorcinol, bis-(4-*tert*-butylbenzoyl)resorcinol, benzoyl resorcinol, 2,4-di-*tert*-butylphenyl 3,5-di-*tert*-butyl-4-hydroxybenzoate, hexadecyl 3,5-di-*tert*-butyl-4-hydroxybenzoate, octadecyl 3,5-di-*tert*-butyl-4-hydroxybenzoate, 2-methyl-4,6-di-*tert*-butylphenyl 3,5-di-*tert*-butyl-4-hydroxybenzoate.
   2.4._Acrylates, for example ethyl α-cyano-β,β-diphenylacrylate, isooctyl α-cyano-β,β-diphenylacrylate, methyl α-carbomethoxycinnamate, methyl α-cyano-β-methyl-*p*-methoxycinnamate, butyl α-cyano-β-methyl-*p*-methoxy-cinnamate, methyl α-carbomethoxy-p-methoxycinnamate, *N*-(β-carbomethoxy-β-cyanovinyl)-2-methylindoline, neopentyl tetra(α-cyano-β,β-diphenylacrylate.
   2.5. Nickel compounds, for example nickel complexes of 2,2'-thio-bis-[4-(1,1,3,3-tetramethyl-butyl)phenol], such as the 1:1 or 1:2 complex, with or without additional ligands such as *n-*butylamine, triethanolamine or *N*-cyclohexyldiethanolamine, nickel dibutyldithiocarbamate, nickel salts of the monoalkyl esters, e.g. the methyl or ethyl ester, of 4-hydroxy-3,5-di-*tert-*butylbenzylphosphonic acid, nickel complexes of ketoximes, e.g. of 2-hydroxy-4-methylphe-nylundecylketoxime, nickel complexes of 1-phenyl-4-lauroyl-5-hydroxypyrazole, with or without additional ligands.
   2.6. Sterically hindered amines, for example bis-(2,2,6,6-tetramethyl-4-piperidyl)sebacate, bis-(2,2,6,6-tetramethyl-4-piperidyl)succinate, bis-(1,2,2,6,6-pentamethyl-4-piperidyl)sebacate, bis-(1,2,2,6,6-pentamethyl-4-piperidyl) *n*-butyl-3,5-di-*tert*-butyl-4-hydroxybenzylmalonate, the condensate of 1-(2-hydroxyethyl)-2,2,6,6-tetramethyl-4-hydroxypiperidine and succinic acid, linear or cyclic condensates of *N*,*N*'-bis-(2,2,6,6-tetramethyl-4-piperidyl)hexamethylenediamine and 4-*tert*-octylamino-2,6-dichloro-1,3,5-triazine, tris-(2,2,6,6-tetramethyl-4-piperidyl)nitrilotriacetate, tetrakis-(2,2,6,6-tetramethyl-4-piperidyl)-1,2,3,4-butanetetracarboxylate, 1,1'-(1,2-ethanediyl)-bis-(3,3,5,5-tetramethylpiperazinone), 4-benzoyl-2,2,6,6-tetramethylpiperidine, 4-stearyloxy-2,2,6,6-tetramethyl-piperidine, bis-(1,2,2,6,6-pentamethylpiperidyl)-2-n-butyl-2-(2-hydroxy-3,5-di-tert-butylbenzyl)malonate, 3-*n*-octyl-7,7,9,9-tetramethyl-1,3,8-triazaspiro[4.5]decane-2,4-dione, linear or cyclic condensates of *N,N*'-bis-(2,2,6,6-tetramethyl-4-piperidyl)hexamethylene-diamine and 4-morpholino-2,6-dichloro-1,3,5-triazine, the condensate of 2-chloro-4,6-bis(4-n-butylamino-2,2,6,6-tetramethylpiperidyl)-1,3,5-triazine and 1,2-bis-(3-aminopropylamino)-ethane, the condensate of 2-chloro-4,6-di-(4-*n*-butylamino-1,2,2,6,6-pentamethylpiperidyl)-1,3,5-triazine and 1,2-bis-(3-aminopropylamino)ethane, 8-acetyl-3-dodecyl-7,7,9,9-tetramethyl-1,3,8-triazaspiro[4.5]decane-2,4-dione, 3-dodecyl-1-(2,2,6,6-tetramethyl-4-piperidyl)pyrrolidine-2,5-dione, 3-dodecyl-1-(1,2,2,6,6-pentamethyl-4-piperidyl)pyrrolidine-2,5-dione, a mixture of 4-hexadecyloxy- and 4-stearyloxy-2,2,6,6-tetramethylpiperidine, a condensate of *N,N*'-bis-(2,2,6,6-tetramethyl-4-piperidyl)hexamethylenediamine and 4-cyclohexylamino-2,6-dichloro-1,3,5-triazine, a condensate of 1,2-bis-(3-aminopropylamino)ethane and 2,4,6-trichloro-1,3,5-triazine as well as 4-butylamino-2,2,6,6-tetramethylpiperidine (CAS Reg. No. [136504-96-6]); a condensate of 1,6-hexanediamine and 2,4,6-trichloro-1,3,5-triazine as well as *N,N*-dibutylamine and 4-butylamino-2,2,6,6-tetramethylpiperidine (CAS Reg. No. [192268-64-7]); *N*-(2,2,6,6-tetramethyl-4-piperidyl)-*n*-dodecylsuccinimide, *N*-(1,2,2,6,6-pentamethyl-4-piperidyl)-*n*-dodecylsuccinimide, 2-undecyl-7,7,9,9-tetramethyl-1-oxa-3,8-diaza-4-oxo-spiro-[4,5]decade, a reaction product of 7,7,9,9-tetramethyl-2-cycloundecyl-1-oxa-3;8-diaza-4-oxo-spiro-[4,5]decane and epichlorohydrin, 1,1-bis-(1,2,2,6,6-pentamethyl-4-piperidyloxy-carbonyl)-2-(4-methoxyphenyl)ethene, *N*,*N*'-bis-formyl-*N*,*N*'-bis-(2,2,6,6-tetramethyl-4-piperidyl)hexamethylenediamine, a diester of 4-methoxymethylenemalonic acid with 1,2,2,6,6-pentamethyl-4-hydroxypiperidine, poly[methylpropyl-3-oxy-4-(2,2,6,6-tetramethyl-4-piperidyl)]siloxane, a reaction product of maleic acid anhydride-α-olefin copolymer with 2,2,6,6-tetramethyl-4-aminopiperidine or 1,2,2,6,6-pentamethyl-4-aminopiperidine, 5-(2-ethylhexanoyl)oxymethyl-3,3,5-trimethyl-2-morpholinone, Sanduvor 3058 (RTM, Clariant; CAS Reg. No. 106917-31-1], 5-(2-ethylhexanoyl)oxymethyl-3,3,5-trimethyl-2-morpholin one, 1,3,5-tris-(*N*-cyclohexyl-*N*-(2,2,6,6-tetramethylpiperazine-3-one-4-yl)amino)-s-triazine, 1,3,5-tris-(*N*-cyclohexyl-*N*-(1,2,2,6,6-pentamethylpiperazine-3-one-4-yl)amino)-*s*-triazine.
   2.7. Oxamides, for example 4,4'-dioctyloxyoxanilide, 2,2'-diethoxyoxanilide, 2,2'-dioctyloxy-5,5'-di-*tert*-butoxanilide, 2,2'-didodecyloxy-5,5'-di-*tert*-butoxanilide, 2-ethoxy-2'-ethyloxanilide, *N*,*N*'-bis(3-dimethylaminopropyl)oxamide, 2-ethoxy-5-*tert*-butyl-2'-ethoxanilide and its mixture with 2-ethoxy-2'-ethyl-5,4'-di-*tert*-butoxanilide, mixtures of *o*- and *p*-methoxy-disubstituted oxanilides and mixtures of *o*- and *p*-ethoxy-disubstituted oxanilides.
   2.8. 2-(2-Hydroxyphenyl)-1,3,5-triazines, for example 2,4,6-tris-(2-hydroxy-4-octyloxyphenyl)-1,3,5-triazine, 2-(2-hydroxy-4-octyloxyphenyl)-4,6-bis-(2,4-dimethylphenyl)-1,3,5-triazine, 2-(2,4-dihydroxyphenyl)-4,6-bis-(2,4-dimethylphenyl)-1,3,5-triazine, 2,4-bis-(2-hydroxy-4-propyloxyphenyl)-6-(2,4-dimethylphenyl)-1,3,5-triazine, 2-(2-hydroxy-4-octyloxyphenyl)-4,6-bis(4-methylphenyl)-1,3,5-triazine, 2-(2-hydroxy-4-dodecyloxyphenyl)-4,6-bis-(2,4-dimethylphenyl)-1,3,5-triazine, 2-(2-hydroxy-4-tridecyloxyphenyl)-4,6-bis-(2,4-dimethylphenyl)-1,3,5-triazine, 2-[2-hydroxy-4-(2-hydroxy-3-butyloxypropoxy)phenyl]-4,6-bis-(2,4-dimethyl)-1,3,5-triazine, 2-[2-hydroxy-4-(2-hydroxy-3-octyloxypropyloxy)phenyl]-4,6-bis-(2,4-dimethyl)-1,3,5-triazine, 2-[4-(dodecyloxy/tridecyloxy-2-hydroxypropoxy)-2-hydroxyphenyl]-4,6-bis-(2,4-dimethylphenyl)-1,3,5-triazine, 2-[2-hydroxy-4-(2-hydroxy-3-dodecyloxypropoxy)phenyl]-4,6-bis-(2,4-dimethylphenyl)-1,3,5-triazine, 2-(2-hydroxy-4-hexyloxy)phenyl-4,6-diphenyl-1,3,5-triazine, 2-(2-hydroxy-4-methoxyphenyl)-4,6-diphenyl-1,3,5-triazine, 2,4,6-tris-[2-hydroxy-4-(3-butoxy-2-hydroxypropoxy)phenyl]-1,3,5-triazine, 2-(2-hydroxyphenyl)-4-(4-methoxyphenyl)-6-phenyl-1,3,5-triazine, 2-{2-hydroxy-4-[3-(2-ethyl-hexyl-1-oxy)-2-hydroxypropyloxy]phenyl}-4,6-bis-(2,4-dimethylphenyl)-1,3,5-triazine, 2,4-bis-(4-[2-ethylhexyloxy]-2-hydroxyphenyl)-6-(4-methoxyphenyl)-1,3,5-triazine.
3. Metal deactivators, for example *N*,*N*'-diphenyloxamide, *N*-salicylal-*N*'-salicyloyl hydrazine, *N*,*N*'-bis(salicyloyl)hydrazine, *N*,*N*'-bis(3,5-di-*tert*-butyl-4-hydroxyphenylpropionyl)hydrazine, 3-salicyloylamino-1,2,4-triazole, bis(benzylidene)oxalyl dihydrazide, oxanilide, isophthaloyl dihydrazide, sebacoyl bisphenylhydrazide, *N*,*N*'-diacetyladipoyl dihydrazide; *N*,*N*'-bis(salicyloyl)oxalyl dihydrazide, *N*,*N*'-bis(salicyloyl)thiopropionyl dihydrazide.
4. Phosphites and phosphonites, for example triphenyl phosphite, diphenylalkyl phosphites, phenyldialkyl phosphites, tris(nonylphenyl) phosphite, trilauryl phosphite, trioctadecyl phosphite, distearylpentaerythritol diphosphite, tris-(2,4-di-*tert*-butylphenyl) phosphite, diisodecyl pentaerythritol diphosphite, bis-(2,4-di-*tert*-butylphenyl)pentaerythritol diphosphite, bis-(2,4-di-cumylphenyl)pentaerythritol diphosphite, bis-(2,6-di-*tert*-butyl-4-methylphenyl)pentaerythritol diphosphite, diisodecyloxypentaerythritol diphosphite, bis-(2,4-di-*tert*-butyl-6-methyl-phenyl)pentaerythritol diphosphite, bis-(2,4,6-tris(*tert*-butylphenyl)pentaerythritol diphosphite, tristearyl sorbitol triphosphite, tetrakis-(2,4-di-*tert*-butylphenyl) 4,4'-biphenylene diphosphonite, 6-isooctyloxy-2,4,8,10-tetra-tert-butyl-12*H*-dibenz[d,g]-1,3,2-dioxaphosphocin, bis-(2,4-di-*tert*-butyl-6-methylphenyl)methyl phosphite, bis-(2,4-di-*tert*-butyl-6-methylphenyl)-ethyl phosphite, 6-fluoro-2,4.,8,10-tetra-*tert*-butyl-12-methyl-dibenz[d,g]-1,3,2-dioxa-phosphocin, 2,2',2"-nitrilo[triethyltris-(3,3',5,5'-tetra-tert-butyl-1,1'-biphenyl-2,2'-diyl)-phosphite], 2-ethylhexyl(3,3',5,5'-tetra-tert-butyl-1,1'-biphenyl-2,2'-diyl)phosphite, 5-butyl-5-ethyl-2-(2,4,6-tri-*tert*-butylphenoxy)-1,3,2-dioxaphosphirane.
   The following phosphites are especially preferred:
   Tris-(2,4-di-*tert*-butylphenyl) phosphite (Irgafos 168 (RTM, Ciba Inc.), tris(nonylphenyl) phosphite, 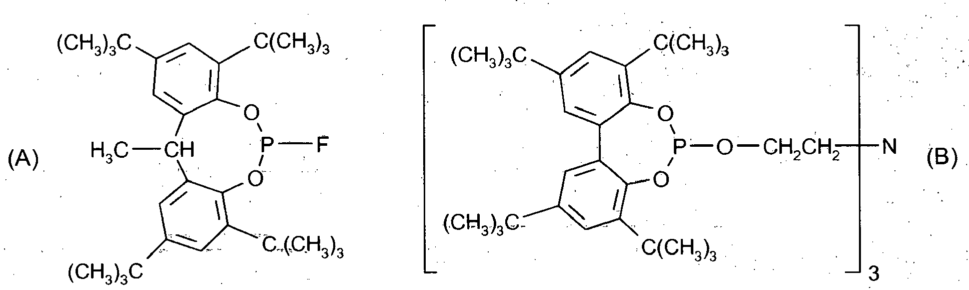 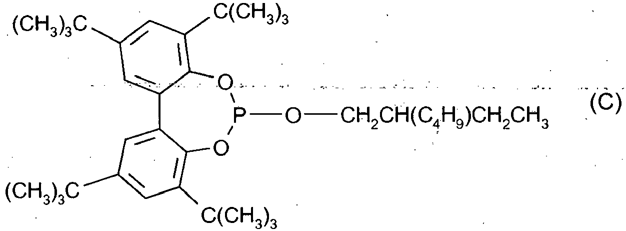 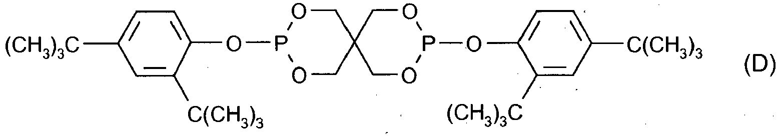 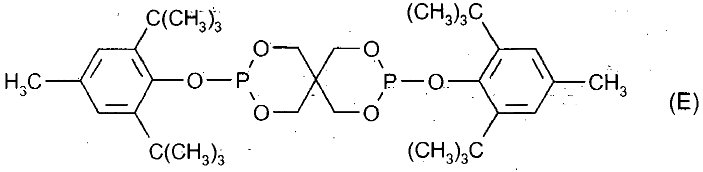 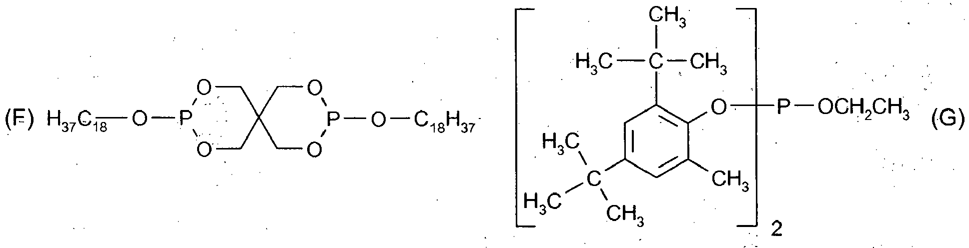
5. Hydroxylamines, for example *N,N*-dibenzylhydroxylamine; *N,N-*diethylhydroxylamine, *N*,*N-*dioctylhydroxylamine, *N*,*N*-dilaurylhydroxylamine, *N*,*N*-ditetradecylhydroxylamine, *N*,*N*-dihexadecylhydroxylamine, *N*,*N*-dioctadecylhydroxylamine, *N*-hexadecyl-*N*-octadecylhydroxyl-amine, *N*-heptadecyl-*N*-octadecylhydroxylamine, *N*,*N*-dialkylhydroxylamine derived from hydrogenated tallow amine.
6. Nitrones, for example, *N*-benzyl-α-phenylnitrone, *N*-ethyl-α-methylnitrone, *N*-octyl-α-heptylnitrone, *N*-lauryl-α-undecylnitrone, *N*-tetradecyl-α-tridecylnnitrone, *N*-hexadecyl-α-pentadecylnitrone, *N*-octadecyl-α-heptadecylnitrone, *N*-hexadecyl-α-heptadecylnitrone, *N-*octadecyl-α-pentadecylnitrone, *N*-heptadecyl-α-heptadecyln itrone, *N*-octadecyl-α-hexa-decylnitrone, nitrone derived from *N*,*N*-dialkylhydroxylamine derived from hydrogenated tallow amine.
7. Thiosynergists, for example dilauryl thiodipropionate, dimistryl thiodipropionate, distearyl thiodipropionate or distearyl disulfide.
8. Peroxide scavengers, for example esters of β-thiodipropionic acid, for example the lauryl, stearyl, myristyl or tridecyl esters, mercaptobenzimidazole or the zinc salt of 2-mercapto-benzimidazole, zinc dibutyldithiocarbamate, dioctadecyl disulfide, pentaerythritol tetrakis-(β-dodecylmercapto)propionate.
9. Polyamide stabilizers, for example copper salts in combination with iodides and/or phosphorus compounds and salts of divalent manganese.
10. Basic co-stabilizers, for example melamine, polyvinylpyrrolidone, dicyandiamide, triallyl cyanurate, urea derivatives, hydrazine derivatives, amines, polyamides, polyurethanes, alkali metal salts and alkaline earth metal salts of higher fatty acids, for example calcium stearate, zinc stearate, magnesium behenate, magnesium stearate, sodium ricinoleate and potassium palmitate, antimony pyrocatecholate or zinc pyrocatecholate.
11. Nucleating agents, for example inorganic substances, such as talcum, metal oxides, such as titanium dioxide or magnesium oxide, phosphates, carbonates or sulfates of, preferably, alkaline earth metals; organic compounds, such as mono- or polycarboxylic acids and the salts thereof, e.g. 4-*tert*-butylbenzoic acid, adipic acid, diphenylacetic acid, sodium-succinate or sodium benzoate; polymeric compounds, such as ionic copolymers (ionomers), or Irgaclear XT 386 (RTM, Ciba). Especially preferred are 1,3:2,4-bis-(3',4'-dimethylbenzylidene)-sorbitol, 1,3:2,4-di(paramethyldibenzylidene)sorbitol and 1,3:2,4-di(benzylidene)sorbitol.
12. Fillers and reinforcing agents, for example calcium carbonate, silicates, glass fibres, glass beads, asbestos, talc, kaolin, mica, barium sulfate, metal oxides and hydroxides, carbon black, graphite, wood flour and flours or fibers of other natural products, synthetic fibers.
13. Other additives, for example pigments, such as carbon black, titanium dioxide in its rutile or anatase forms, color pigments; plasticisers; lubricants; emulsifiers; rheology additives; antislip / antiblock additives; catalysts; flow-control agents; optical brighteners; antistatic agents and blowing agents.
14. Benzofuranones and indolinones, for example those disclosed in U.S. 4,325,863; U.S. 4,338,244; U.S. 5,175,312; U.S. 5,216,052; U.S. 5,252,643; DE-A-4316611; DE-A-4316622; DE-A-4316876; EP-A-0589839, EP-A-0591102; EP-A-1291384 or 3-[4-(2-acetoxyethoxy)phenyl]-5,7-di-*tert*-butylbenzofuran-2-one, 5,7-di-*tert*-butyl-3-[4-(2-stearoyloxy-ethoxy)phenyl]benzofuran-2-one, 3,3'-bis[5,7-di-*tert*-butyl-3-(4-[2-hydroxyethoxy]phenyl)benzofuran-2-one], 5,7-di-*tert*-butyl-3-(4-ethoxyphenyl)benzofuran-2-one, 3-(4-acetoxy-3,5-dimethylphenyl)-5,7-di-*tert*-butylbenzofuran-2-one, 3-(3,5-dimethyl-4-pivaloyloxyphenyl)-5,7-di-*tert*-butylbenzofuran-2-one, 3-(3,4-dimethylphenyl)-5,7-di-*tert*-butylbenzofuran-2-one, 3-(2,3-dimethylphenyl)-5,7-di-*tert*-butylbenzofuran-2-one, 3-(2-acetyl-5-isooctylphenyl)-5-isooctyl-benzofuran-2-one.

Preferred is a photovoltaic module wherein the layer or layers of component (2) contain one or more further components selected from the group of benzotriazole UV absorber; triazine-based UV-absorber, sterically hindered amine, phenolic antioxidant, basic co-stabilizer and neutralizer.

Preferred is a photovoltaic module wherein the layer or layers of component (2) contain a further component selected from the group of hindered amine light stabilizer as listed under sterically hindered amine at topic 2.6.

The layer or layers of present component (2) have for example a thickness of 10 to 2 000 µm, in particular 50 to 1000 µm.

The layer or layers of present component (2) have excellent optical properties such as optical transparency, mechanical strength high enough to prevent e.g. contraction of a polarizer with high contractability, thermal resistance which can endure the high temperature which is applied during processes, and the like.

The layer or layers of present component (2) have preferably a light transmittance at a wavelength of 280-340 nm of less than 5 %.

The layer or layers of present component (2) preferably have a low haze value of e.g. less than 5 (determined at a 100 µm film) according to ASTM D 1003.

The layer or layers of present component (2) are typically generated during the manufacturing process by converting sheets, which are made from the synthetic polymer as component (A) comprising the UV absorber as component (B) and optionally further additives. Said sheets can be prepared by conventional methods for plastic processing which are well known to those skilled in the art; for example solution casting methods, melt molding methods such as melt extrusion molding, press molding or injection molding, or the like. These methods may optionally contain additional processing steps such as orientation, lamination, co-extrusion or the like.

The present compound of formula I, optional further additives and optional peroxides can be be incorporated into the synthetic polymer prior or during the transformation into sheet or sheets. This or these sheets are afterwards converted during manufacturing of the photovoltaic module into the layer or layers of present component (2). These methods of incorporation are not particularly limited and well known to those skilled in the art. There may be mentioned, for example, the incorporation of the compounds of the formula I into the synthetic polymer or the use of a masterbatch of the compounds of the formula I for the incorporation into the synthetic polymer. It is for example possible to supply the compounds of the formula I during the melt extrusion molding; and the like, and any of these methods may be employed.

A compound of formula I is present in the synthetic polymer in component (2) in an amount of 0.01% to 10%, preferably 0.05% to 5% and particularly of 0.05% to 2%, relative to the weight of the synthetic polymer.
Preferred is a photovoltaic module wherein component (B) is present in 0.01% to 10% relative to the weight of component (A).

A further additive may be present in the synthetic polymer in an amount of 0.001% to 10%, preferably 0.01 % to 5% and particularly of 0.01 % to 2% relative to the weight of the synthetic polymer.
Preferred is a photovoltaic module wherein a further additive is present in component (A) in an amount of 0.001% to 10% relative to the weight of component (A).

If desired, the sheet or sheets as precursors of the layer or layers of present component (2) may be subjected to a treatment. A treatment is adavantageous for improving the mutual adhesiveness of the sheets to other layers. Particularly, a surface treatment such as the application of a special coating by an adhesive to the sheet surface can improve the laminating process between sheets transforming into layers and layers, which remain mechanically rigid during the manufacturing process of the photovoltaic module. Here, mechanical rigidity refers to layers, which are not sensitive towards the warming applied during the manufacturing process of the photovoltaic module, for example layers out of glass, metal or polymers like specific polyesters.

Alternatively or in addition to a surface treatment of the sheet is the incorporation of an adhesion promoter into the synthetic polymer to improve the adhesiveness of the layer formed from the sheet during the manufacture of the photovoltaic module. Said adhesion promoter can be incorporated into the synthetic polymer similar to the methods mentioned for optional further additives and optional peroxides. The incorporation of the adhesion promoter can be performed simultaneously with optional further additives and optional peroxides, for example during a sheet formation out of poly(ethylene-co-vinylacetate).

Examples for adhesion promoters are silanes with a coupling functionality.
1. Vinylsilane, for example vinylchlorosilane, vinyl-tris-(2-methoxyethoxy)-silane, vinyl-triethoxy-silane, vinyl-triacetoxy-silane or vinyl-trimethoxy-silane.
2. Acryloxysilane, for example (3-(methacryloxy)propyl)-trimethoxy-silane.
3. Epoxysilane, for example (2-(7-oxa-bicyclo[4.1.0]hept-3-yl)ethyl)-trimethoxy-silane, (3-oxiranylmethoxy-propyl)-trimethoxy-silane or (3-oxiranylmethoxy-propyl)-diethoxymethyl-silane.
4. Aminosilane, for example (*N*-(2-aminoethyl)-3-aminopropyl)-trimethoxy-silane, (*N*-(2-aminoethyl)-3-aminopropyl)-dimethoxy-methyl-silane, (3-aminopropyl)-triethoxy-silane or (*N*-phenyl-3-aminopropyl)-trimethoxy-silane.
5. Other types of silanes, for example (3-mercaptopropyl)-trimethoxy-silane or (3-chloropropyl)-trimethoxysilane.

Preferred as adhesion promoter is (3-(methacryloxy)propyl)-trimethoxy-silane.

The typical amount of an adhesion promoter in a synthetic polymer is from 0.01% to 5%, in particular from 0.1% to 2%.
Preferred is a photovoltaic module wherein an adhesion promoter is present in component
(A) in an amount of 0.01% to 5% relative to the weight of component (A).

A standard manufacturing procedure for a photovoltaic module is exemplified for a module containing crystalline silicon, two layers of crosslinked poly(ethylene-co-vinylacetate), a front support layer out of glass and a back support layer out of polyester.

The standard structure of a photovoltaic module comprising cells which contain themselves photovoltaic semiconductors out of crystalline silicon is called superstrate structure. Such an element of superstrate structure is manufactured by arranging two-dimensionally several cells, which contain photovoltaic semiconductors and which are connected in tandem and in parallel.
A sheet out of poly(ethylene-co-vinylacetate) containing an UV-absorber according to formula I as component (B), a peroxide and optionally further additives, is placed on a sheet out of glass. This glass sheet will later be the front support layer of the finished photovoltaic module. On top of said sheet out of poly(ethylene-co-vinylacetate) is put the aforementioned arrangement of cells, which is followed by another sheet out of poly(ethylene-co-vinylacetate) containing an UV-absorber according to formula I as component (B), a peroxide and optionally further additives. Finally, a sheet out of polyester containing an UV-absorber according to formula I as component (B) and optionally further additives is placed on top. Said sheet out of polyester will later be the back support layer of the finished photovoltaic module.
The whole stack is now processed in a laminator, wherein as the first step a warming up to 120°C takes place under vacuum and the temperare is maintained at this temperature for 3 to 60 minutes, e.g. 20 minutes. During this period, the two sheets out of poly(ethylene-co-vinylacetate) melt by the heat (but not the polyester sheet as back support layer) and thereby encapsulate the cell arrangement and glue the glass and polyester sheets. In a second step, the whole stack is warmed further up to 150°C in the laminator and kept at this temperature for 5 to 60 minutes, e.g. 20 minutes, in order to initiate and complete the crosslinking reaction of poly(ethylene-co-vinylacetate). Said crosslinking leads to improved mechanical properties in the layers formed now by the original sheets out of poly(ethylene-co-vinylacetate). After cooling down the of the stack, the photovoltaic module is completed by sealing of its edges, framing and installation of cables and a junction box.

With other photovoltaic module systems employing other photovoltaic semiconductors, such as a photovoltaic module containing amorphous silicon or a photovoltaic module containing a composite semiconductor, the cells may be generated by different ways, for example by spattering or chemical vapor deposition. However, the process of encapsulation is always similar, which means, the stack built from the sheets is processed in the laminator in order to melt the synthetic polymer foreseen as encapsulant, and initiate - if chosen - the crosslinking reaction afterwards.

Another embodiment of the present invention is a method for stabilizing a synthetic polymer in one or more layers being present in a photovoltaic module, which comprises the addition of a compound of formula I as defined in claim 1 into the synthetic polymer.

Another embodiment of the present invention is the use of a compound of formula I for stabilizing a synthetic polymer in one of more layers being present in a photovoltaic module. Preferred is stabilization against degradation by light and heat.

Another embodiment of the present invention is a method for peroxide induced crosslinking of a synthetic polymer in one or more layers being present in a photovoltaic module, which comprises the addition of a compound of formula I as defined in claim 1 and an organic peroxide compound into the synthetic polymer.

Another embodiment of the present invention is the use of a compound of formula I for low-interfering in the process of peroxide induced crosslinking of a synthetic polymer in one or more layers being present in a photovoltaic module.

The compounds of formula I can be prepared by known methods, for examples as described in US 3580927.

### Example 1: Stabilization of crosslinked poly(ethylene-co-vinylacetate)

100 parts of pellets of ELVAX PV 1400 (RTM DuPont Ltd, poly(ethylene-co-vinylacetate) with 32% relative weight content of vinyl acetate) are soaked with 1 part liquid Luperox 101 (RTM Arkema Inc., containing 2,5-dimethyl-2,5-di-(*tert*-butylperoxy)hexane [CAS-No. 78-63-7]) without a further solvent in a rotating glass flask for 2 hours at room temperature. The soaked pellets and the respective relative weight amount of additive according to table 1 are compounded below 70°C for 10 minutes by a calendaring mixer (Schwabenthan Inc.). The prepared compounded material is transformed by a compression molding machine (Suter Inc.) at 150°C for 15 minutes to a compressed sheet of 0.5 mm thickness. A vacuum, i.e. a pressure lower than atmospheric pressure, is not applied during this sheet preparation.

The prepared sheet is exposed to an accelerated weathering test, which is performed using an Eye Super UV tester, SUV-W151 (Iwasaki Electric Co., Inc.), operated with 100 mW/cm² irradiance, 63°C black panel temperature, 50% humidity and without water spray. Initially and after regular intervals, the yellowness index (YI) is measured according to Japanese Industry Standard K7103 with a spectrophotometer (Konika-Minolta CM-3700d). The maintainance of a low value for the yellowness index is desired.

**Table 1: Yellowness index of prepared sheets (0.5 mm thickness) before and after weathering**

| sheet | additive added prior to compounding in relation to 100 parts of soaked pellets | YI after hours (h) weathering | |
|---|---|---|---|
| | | 0 h | 500 h |
| No. 1^{a)} | 0.3 parts of Chimassorb 81^{c)} | 1.5 | 6.9 |
| No. 2^{b)} | 0.3 parts of UVA-1^{d)} | 1.4 | 1.4 |

| | | | |
|---|---|---|---|
| a) comparative b) according to the invention c) Chimassorb 81 (RTM Ciba): (2-hydroxy-4-octyloxy-phenyl)phenylmethanone 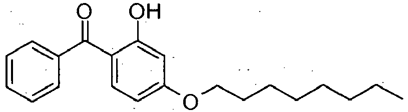 d) UVA-1: {4-[4-(4-benzoyl-3-hydroxy-phenoxy)butoxy]-2-hydroxy-phenyl}phenylmethanone 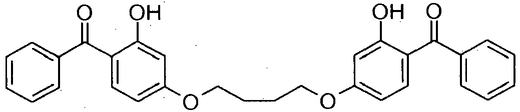 | | | |

### Example 2: Isothermal thermogravimetric analysis at 150°C

The weight loss of 20 mg of additive in powder form is measured during heating to 150°C and keeping at 150°C for 30 minutes under a nitrogen flow of 100 mL / min and atmospheric pressure by thermogravimetric analysis (TGA / SDTA 851 by Mettler Ltd).

**Table 2: Relative weight loss during isothermal thermogravimetric analysis at 150°C**

| additive | weight loss |
|---|---|
| Chimassorb 81^{c), a)} | < 0.5% |
| UVA-1^{d), b)} | < 0.5% |

The example reveals that at 150°C and atmospheric pressure, i.e. the highest temperature and the lowest pressure occurring during example 1, the volatilities of both additives are negligible.

### Example 3: Influence of additive on peroxide-induced crosslinking of poly(ethylene-co-vinylacetate)

100 parts of pellets of ELVAX PV 1400 (RTM DuPont Ltd, poly(ethylene-co-vinylacetate) with 32% relative weight content of vinyl acetate) are soaked with 1 part of liquid Luperox TBEC (RTM Arkema Inc., containing peroxycarbonic acid *O*-*O*-*tert*-butyl ester *O*-isopropyl ester [CAS-No. 34443-12-4]) without a further solvent in a rotating glass flask for 2 hours at room temperature.
The soaked pellets and the respective relative weight amount of additive according to table 2 are compounded below 70°C for 10 minutes by a calendaring mixer (Schwabenthan Inc.). The curing kinetics is measured by recording the increase of viscosity value over the time. The deletion of viscosity value correlates with the level of crosslinking. The deletion of viscosity of the material is measured by a dynamic rheometer (apparatus SIS V50 from Scarabaeus Inc.) at 150°C with 0.5 degree amplitude and 1.67 Hz for 30 minutes.

**Table 3: Development of torques value during crosslinking of poly(ethylene-co-vinylacetate)**

| | S' = torque (dNm) | | |
|---|---|---|---|
| additive added prior to compounding in relation to 100 parts of soaked pellets | after 3 min | after 15 min | after 30 min (max. torque value) |
| No additive added | 1.27 | 2.4 | 2.42 |
| 5 parts of Chimassorb 81^{c), a)} | 0.84 | 1.78 | 1.87 |
| 5 part of UVA-1^{d), b)} | 0.93 | 1.84 | 1.94 |

After having reached 150°C, the starting values of all three materials are initially close to zero for the moment, when the previously solid compounded materials become liquid. This moment of melting takes place for all materials at nearly the same time and is observed between 0 and 1 min at the stated time scale. While heating, peroxide decomposition starts (so-called induction phase) and induces the crosslinking indicated by the measured torque values. After around 25 minutes, the torque value of each material reaches a final plateau and is determined at 30 minutes.
Torque values closer to no UV absorber are desired.

## Claims

1. A photovoltaic module comprising the components:
(1) a photovoltaic semiconductor and
(2) one or more layers containing
(A) a synthetic polymer and
(B) an UV absorber of the formula I 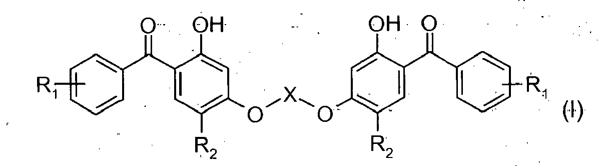 wherein
X is a straight or branched chain C₁-C₁₆ alkylene, o-, m- or p-xylylene or an oxaalkanediyl of the formulae -CH₂CH₂[OCH₂CH₂]ₙ-, -CH₂CH(CH₃)[OCH₂CH(CH₃)]ₙ- or -CH₂CH₂CH₂[OCH₂CH₂CH₂]ₙ-, where n is 1-4;
R₁ is hydrogen, straight or branched chain C₁-C₁₈ alkyl, straight or branched chain C₁-C₁₈ alkoxy or chloro;
R₂ is hydrogen or straight or branched chain C₁-C₁₈ alkyl.

2. A photovoltaic module according to claim 1 wherein the component (A) is a thermoplastic synthetic polymer:

3. A photovoltaic module according to claim 1 wherein the component (A) is a crosslinked synthetic polymer.

4. A photovoltaic module according to any one of claims 1 to 3 wherein the component (A) is selected from poly(ethylene-co-vinylacetate), poly(ethylene-co-methacrylic acid) and salts thereof, poly(ethylene-co-acrylic acid) and salts thereof, polyurethane, poly(vinyl butyral), polymethacrylate, polyacrylate, polyester and silicone.

5. A photovoltaic module according to any one of claims 1 to 4 wherein the component (A) is poly(ethylene-co-vinylacetate).

6. A photovoltaic module according to any one of claims 1 or 3 to 5 wherein the component (A) is crosslinked poly(ethylene-co-vinylacetate).

7. A photovoltaic module according to any one of claims 3 to 6, wherein crosslinking originates from addition of an organic compound with peroxide functionality to a formerly thermoplastic polymer.

8. A photovoltaic module according to any one of claims 1 to 7 wherein in formula I X is C₂-C₁₀ alkylene.

9. A photovoltaic module according to any one of claims 1 to 8 wherein in formula I R₂ is hydrogen or *tert*-butyl.

10. A photovoltaic module according to any one of claims 1 to 9 wherein the photovoltaic semiconductor (1) contains crystalline silicon, amorphous silicon, CuInSe₂, Cu(InGa)Se₂ or CdTe-CdS.

11. A photovoltaic module according to any one of claims 1 to 10 wherein the layer or layers of component (2) contain one or more further components selected from the group of benzotriazole UV absorber, triazine-based UV-absorber, sterically hindered amine, phenolic antioxidant, basic co-stabilizer and neutralizer.

12. A photovoltaic module according to any one of claims 1 to 11 wherein the layer or layers of component (2) have a thickness of 10 to 2 000 µm.

13. A photovoltaic module according to any one of claims 1 to 12 wherein component (B) is present in 0.01% to 10% relative to the weight of component (A).

14. A method for stabilizing a synthetic polymer in one or more layers being present in a photovoltaic module, which comprises the addition of a compound of formula I as defined in claim 1 into the synthetic polymer.

15. A method for peroxide induced crosslinking of a synthetic polymer in one or more layers being present in a photovoltaic module, which comprises the addition of a compound of formula I as defined in claim 1 and an organic peroxide compound into the synthetic polymer.

## Patentansprüche

1. Photovoltaikmodul mit den folgenden Komponenten:
(1) einem photovoltaischen Halbleiter und
(2) einer oder mehreren Schichten, enthaltend
(A) ein synthetisches Polymer und
(B) einen UV-Absorber der Formel I 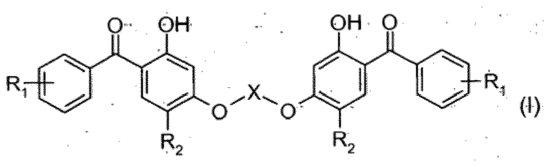 worin
X für ein gerad- oder verzweigtkettiges C₁-C₁₆-Alkylen, o-, m- oder p-Xylylen oder ein Oxaalkandiyl der Formeln -CH₂CH₂ [OCH₂CH₂]ₙ-, -CH₂CH (CH₃) [OCH₂CH (CH₃)]ₙ- oder -CH₂CH₂CH₂[OCH₂CH₂CH₂]ₙ-, wobei n 1-4 bedeutet, steht;
R₁ für Wasserstoff, gerad- oder verzweigt-kettiges C₁-C₁₈-Alkyl, gerad- oder verzweigt-kettiges C₁-C₁₈-Alkoxy oder Chlor steht;
R₂ für Wasserstoff oder gerad- oder verzweigt-kettiges C₁-C₁₈-Alkyl steht.

2. Photovoltaikmodul nach Anspruch 1, wobei es sich bei der Komponente (A) um ein thermoplastisches synthetisches Polymer handelt.

3. Photovoltaikmodul nach Anspruch 1, wobei es sich bei der Komponente (A) um ein vernetztes synthetisches Polymer handelt.

4. Photovoltaikmodul nach einem der Ansprüche 1 bis 3, wobei die Komponente (A) aus Poly(ethylen-co-vinylacetat), Poly(ethylen-co-methacrylsäure) und Salzen davon, Poly(ethylen-co-acrylsäure) und Salzen davon, Polyurethan, Poly(vinylbutyral), Polymethacrylat, Polyacrylat, Polyester und Silikon ausgewählt ist.

5. Photovoltaikmodul nach einem der Ansprüche 1 bis 4, wobei es sich bei der Komponente (A) um Poly-(ethylen-co-vinylacetat) handelt.

6. Photovoltaikmodul nach einem der Ansprüche 1 oder 3 bis 5, wobei es sich bei der Komponente (A) um vernetztes Poly(ethylen-co-vinylacetat) handelt.

7. Photovoltaikmodul nach einem der Ansprüche 3 bis 6, wobei die Vernetzung sich aus der Addition einer organischen Verbindung mit Peroxidfunktionalität an ein vorher thermoplastisches Polymer ergibt.

8. Photovoltaikmodul nach einem der Ansprüche 1 bis 7, wobei in Formel I X für C₂-C₁₀-Alkyl steht.

9. Photovoltaikmodul nach einem der Ansprüche 1 bis 8, wobei in Formel I R₂ für Wasserstoff oder *tert-*Butyl steht.

10. Photovoltaikmodul nach einem der Ansprüche 1 bis 9, wobei der photovoltaische Halbleiter (1) kristallines Silicium, amorphes Silicium, CuInSe₂, Cu(InGa)Se₂ oder CdTe-CdS enthält.

11. Photovoltaikmodul nach einem der Ansprüche 1 bis 10, wobei die Schicht bzw. Schichten von Komponente (2) eine oder mehrere weitere Komponenten aus der Gruppe Benzotriazol-UV-Absorber, auf Triazin basierender UV-Absorber, sterisch gehindertes Amin, phenolisches Antioxidans, basischer Co-Stabilisator und Neutralisator enthält bzw. enthalten.

12. Photovoltaikmodul nach einem der Ansprüche 1 bis 11, wobei die Schicht bzw. Schichten von Komponente (2) eine Dicke von 10 bis 2000 µm aufweist bzw. aufweisen.

13. Photovoltaikmodul nach einem der Ansprüche 1 bis 12, wobei Komponente (B) in einer Menge von 0,01% bis 10%, bezogen auf das Gewicht von Komponente (A), vorliegt.

14. Verfahren zur Stabilisierung eines synthetischen Polymers in einer oder mehreren Schichten, die in einem Photovoltaikmodul vorliegt bzw. vorliegen, bei dem man eine Verbindung der Formel I gemäß Anspruch 1 zu dem synthetischen Polymer gibt.

15. Verfahren zur peroxidinduzierten Vernetzung eines synthetischen Polymers in einer oder mehreren Schichten, die in einem Photovoltaikmodul vorliegt bzw. vorliegen, bei dem man eine Verbindung der Formel I gemäß Anspruch 1 und eine organische Peroxidverbindung zu dem synthetischen Polymer gibt.

## Revendications

1. Module photovoltaïque comprenant les composants :
(1) un semi-conducteur photovoltaïque et
(2) une ou plusieurs couches contenant
(A) un polymère synthétique et
(B) un absorbeur d'UV de la formule I 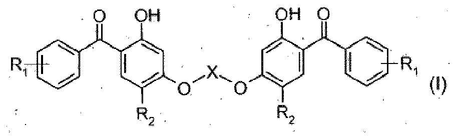 dans laquelle
X représente un alkylène en C₁-C₁₆ à chaîne linéaire ou ramifiée, un o-, m- ou p-xylylène ou un oxaalcanediyle des formules -CH₂CH₂[OCH₂CH₂]ₙ-, -CH₂CH (CH₃) [OCH₂CH (CH₃)]ₙ-ou -CH₂CH₂CH₂[OCH₂CH₂CH₂]ₙ-, où n vaut 1-4 ;
R₁ représente un hydrogène, un alkyle en C₁-C₁₈ à chaîne linéaire ou ramifiée, un alcoxy en C₁-C₁₈ à chaîne linéaire ou ramifiée ou un chlore ;
R₂ représente un hydrogène ou un alkyle en C₁-C₁₈ à chaîne linéaire ou ramifiée.

2. Module photovoltaïque selon la revendication 1 dans lequel le composant (A) est un polymère synthétique thermoplastique.

3. Module photovoltaïque selon la revendication 1 dans lequel le composant (A) est un polymère synthétique réticulé.

4. Module photovoltaïque selon l'une quelconque des revendications 1 à 3 dans lequel le composant (A) est choisi parmi le poly(éthylène-co-acétate de vinyle), le poly(éthylène-co-acide méthacrylique) et ses sels, le poly(éthylène-co-acide acrylique) et ses sels, le polyuréthane, le poly(vinylbutyral), le polyméthacrylate, le polyacrylate, le polyester et le silicone.

5. Module photovoltaïque selon l'une quelconque des revendications 1 à 4 dans lequel le composant (A) est le poly(éthylène-co-acétate de vinyle).

6. Module photovoltaïque selon l'une quelconque des revendications 1 ou 3 à 5 dans lequel le composant (A) est le poly(éthylène-co-acétate de vinyle) réticulé.

7. Module photovoltaïque selon l'une quelconque des revendications 3 à 6, dans lequel la réticulation provient de l'addition d'un composé organique avec une fonctionnalité peroxyde à un polymère précédemment thermoplastique.

8. Module photovoltaïque selon l'une quelconque des revendications 1 à 7 dans lequel, dans la formule I, X représente un alkylène en C₂-C₁₀.

9. Module photovoltaïque selon l'une quelconque des revendications 1 à 8 dans lequel, dans la formule I, R₂ représente un hydrogène ou un *tert*-butyle.

10. Module photovoltaïque selon l'une quelconque des revendications 1 à 9 dans lequel le semi-conducteur photovoltaïque (1) contient du silicium cristallin, du silicium amorphe, du CuInSe₂, du Cu(InGa)Se₂ ou du CdTe-CdS.

11. Module photovoltaïque selon l'une quelconque des revendications 1 à 10 dans lequel la couche ou les couches du composant (2) contiennent un ou plusieurs autres composants choisis dans le groupe constitué par un absorbeur d'UV à base de benzotriazole, un absorbeur d'UV à base de triazine, une amine stériquement encombrée, un antioxydant phénolique, un costabilisant basique et un neutralisant.

12. Module photovoltaïque selon l'une quelconque des revendications 1 à 11 dans lequel la couche ou les couches du composant (2) ont une épaisseur de 10 à 2000 µm.

13. Module photovoltaïque selon l'une quelconque des revendications 1 à 12 dans lequel le composant (B) est présent à 0,01 % à 10 %, rapporté au poids du composant (A).

14. Procédé de stabilisation d'un polymère synthétique dans une ou plusieurs couches présentes dans un module photovoltaïque, qui comprend l'addition d'un composé de formule I tel que défini dans la revendication 1 dans le polymère synthétique.

15. Procédé de réticulation induite par peroxyde d'un polymère synthétique dans une ou plusieurs couches présentes dans un module photovoltaïque, qui comprend l'addition d'un composé de formule I tel que défini dans la revendication 1 et d'un composé peroxydique organique dans le polymère synthétique.
